# EUROPEAN PATENT SPECIFICATION

(11) **EP 0 420 850 B1**
(45) Date of publication and mention of the grant of the patent: **25.08.1993**
(21) Application number: 89902185.1
(22) Date of filing: 11.01.1989
(51) Int. Cl.: C23C 18/28

(54) **SENSITIZING ACTIVATOR FOR CHEMICAL PLATING**
AKTIVIERUNGSLÖSUNG ZUR STROMLOSEN METALLISIERUNG
ACTIVATEUR DE SENSIBILISATION POUR PLACAGE CHIMIQUE

(30) Priority: 02.09.1988 US 239935
(43) Date of publication of application: 10.04.1991
(73) Proprietor: SOLUTION TECHNOLOGY SYSTEMS, Redlands, CA 92373 (US)
(72) Inventor: KIYOSHI, Okabayashi, Tokyo (JP)
(74) Representative: Goldin, Douglas Michael
(86) International application number: PCT/US89/00102
(87) International publication number: WO 89/06710

(56) References cited:
- US-A- 3 904 792
- US-A- 4 061 588
- US-A- 4 448 804
- US-A- 4 481 236

## Description

The present invention relates to a sensitizing activator for chemical plating. Especially, the present invention relates to a sensitising activator for use in chemical plating of through holes of a multi-layer printed circuit board. More particularly, the present invention relates to an improved sensitising activator having an activity of uniformly and efficiently depositing a substance capable of catalytically depositing a plating metal from a plating solution, such as colloidal palladium, on the surface of a material to be plated in advance.

It is known that in conventional plating the operation of depositing a catalytic substance such as colloidal palladium on the surface of a resin should be performed before chemical plating. In order to reduce the manufacturing cost of a chemically plated product, how to deposit this colloidal palladium uniformly and efficiently is one of the important problems. The inventor previously found that by using an activating treating agent formed by adding vanillin and an acidic dye to a hydrochloric acid solution of palladium chloride, the amount of palladium used can be reduced and a product excellent in the plating quality over a conventional product can be obtained (see, for example, Japanese Patent Application No. 136473/1974). The inventor furthered his research and found that when a hydrochloric acid solution of palladium chloride and tin chloride is used instead of the hydrochloric acid solution containing palladium chloride alone as taught in the invention of Japanese Patent Application No. 136473/1974, colloidal palladium can be efficiently deposited and a product improved in the plating quality can be obtained by adding vanillin alone without using any acidic dye, as disclosed in Japanese Patent Publication No. 34220/1980.

The sensitizing activator proposed in the Japanese Patent Publication No. 34220/1980 (hereinafter referred to as "conventional technique") is effective in the sensitising step in chemical plating of excellent quality plated-through holes of a single layer printed circuit board. However, when this sensitizing activator is used for plating of through holes of a multi-layer printed circuit board, hydrochloric acid contained in the sensitising activator causes corrosion of the black oxide that is normally formed on an inner copper foil of a copper-clad resin laminate board in the inner wall portions of the through holes of the copper-clad board, and the sensitizing activator permeates between the copper-clad resin laminate layers and is left therein and, since hydrochloric acid contained in the sensitizing activator has an electrical conductivity, the insulation between adjacent through holes becomes insufficient or the bonding between the copper-clad resin laminate layers is weakened to cause delamination.

Accordingly, in the case where the conventional sensitizing activator is used in the step of plating through holes of a multi-layer printed circuit board, the conditions such as dipping time, the concentration and the temperature are restricted and the process control is difficult. Namely, it is difficult to shorten the dipping time or reduce the hydrochloric acid concentration so that the black oxide of the inner copper foil of the resin laminate board is hardly corroded, and the sensitizing treatment is insufficient.

US-A-3,904,792 discloses a sensitizing activator for chemical plating which comprises stannous and palladium chlorides, colloidally dispersed in an aqueous solution of sodium chloride and an acid such as hydrochloric or sulfuric acid.

We have now found, in accordance with the present invention, that if the stannous chloride and palladium chloride are separately dissolved in non-acid sodium chloride solutions, the sodium chloride solution containing an aromatic aldehyde, which are subsequently combined, the resulting colloidal dispersion is more uniform than those of the prior art and gives rise to a more satisfactory sensitizing activator. The colloidal dispersion obtained by the process of this invention may subsequently be further concentrated to give a stable concentrate that can be supplied in this form to the ultimate user.

In accordance with a further feature of the invention, a sensitizing activator for use in chemical plating can be prepared from a concentrate of the invention by dilution with water e.g. by addition of a dilute concentration of a polyvalent acid to prevent oxidation.

In particular, it has been discovered that the defects of the conventional sensitizing activator object can be overcome by using a polyvalent acid, which does not corrode the black oxide formed on the inner copper foil of the copper-clad resin laminate board, instead of conventional hydrochloric acid which corrodes this black oxide. Preferably he acid is sulfuric acid, which not only provides exceptionally satisfactory results, but also is most inexpensive and readily available.

The activator also includes an aromatic aldehyde for promoting uniform dispersion of the dissolved particles, and for enhancing adhesive properties of the activator. The aldehyde can be vanillin. Preferably there is a concentration of 0.015 to 0.03 grams per liter of vanillin, 5 to 10 grams per liter of stannous chloride, 0.1 to 0.2 grams per liter of palladium chloride, 0.05 to 10 volume/volume percent of sulfuric acid, and 50 to 280 grams per liter of sodium chloride.

In one preferred formulation, the sodium chloride concentration is about 280 grams per liter, the sulfuric acid concentration being less than about 0.1 percent. In another preferred formulation, the sodium chloride concentration is about 50 grams per liter and the sulfuric acid concentration is about 5 percent.

The concentrates of the invention are prepared in the absence of a polyvalent acid. However, when these concentrates are diluted prior to use, an appropriate concentration of the polyvalent acid is introduced to prevent oxidation of the components of the activator. The exact acid concentration will depend to a certain extent or the extent to which the concentrate is diluted prior to use but will normally be in the range of 0.05 to about 10 percent by volume of the diluted activator, preferred ranges being about 0.5 to about 10 percent, or about 0.05 to about 5 percent or between about 0.05 and about 0.01 percent.

In another aspect of the invention, the activator has the stannous chloride in a weight per unit volume concentration of about 25 to about 100 tines a corresponding concentration of palladium chloride. Thus the activator can be supplied in concentrated form for later dilution by an aqueous sodium chloride and sulfuric acid solution, the sodium chloride and sulfuric acid being commonly available from sources local to an end use of the activator. More preferably, the concentration of the stannous chloride is approximately 50 times the concentration of palladium chloride, for facilitating the removal of tin in the plating process, and for limiting particle size in the activator. In particular, the concentrated activator can be diluted to about 1 percent in volume in the sodium chloride sulfuric acid solution. The stannous chloride car be in a concentration of about 500 grams per liter, and the palladium chloride can be in a concentration of frog about 10 to about 20 grams per liter. The activator can contain vanillin in a concentration of from about 0.075 to about 0.3 per unit of palladium chloride, preferably about 0.15.

The present invention is useful in the sensitizing treatment for facilitating general chemical plating, providing complete permeation and adsorption in fine hole portions of a material to be plated, for excellent uniformity of the plating. More particularly, the invention finds application in the plating of through-holes of a multi-layer printed circuit board.

In a further aspect of the invention, there is provided a method for plating a substrate, comprising the steps of:
(a) dipping the substrate into a sensitizing activator comprising:
   (i) stannous chloride;
   (ii) palladium chloride;
   (iii) sodium chloride in an aqueous solution,
      wherein the weight concentration of stannous chloride is from about 25 to about 100 times the weight concentration of palladium chloride;
   (iv) sulfuric acid in a volumetric concentration of from about 0.05 percent to about 5 percent;
   and (v) an aromatic aldehyde
(b) rinsing the substrate; and
(c) dipping the substrate into a chemical plating bath comprising the metal to be plated.

The method can include the subsequent further step of etching oxide from copper cladding of the substrate, by dipping the board in a suitable etchant. The etchant can be a solution of sodium persulfate. Also, the method can include the further step of dipping the substrate in an approximate 10 percent concentration of sulfuric acid, for accelerating the plating.

In yet a further aspect, the invention provides a method for producing a sensitizing activator for chemical plating, comprising the steps of preparing an aqueous solution of sodium chloride, and an aromatic aldehyde, and dissolving stannous chloride and palladium chloride into the solution of sodium chloride. The step of dissolving the stannous chloride and the palladium chloride in the sodium chloride solution comprises the further steps of:
(a) dissolving the stannous chloride in a first portion of the sodium chloride solution;
(b) dissolving the palladium chloride in a second portion of the sodium chloride solution; and
(c) adding the dissolved palladium chloride to the dissolved stannous chloride.

### DESCRIPTION

In accordance with the present invention, there is provided a sensitizing activator for chemical plating, which comprises stannous chloride and palladium chloride colloidally dispersed in an aqueous solution of sodium chloride, which is used in the presence of a polyvalent acid such as sulfuric acid. The polyvalent acid keeps the pH of the activator slightly acidic, acting to prevent oxidation of the other components of the activator. It is to be understood that other sources of halides than chlorine could be used in the practice of the present invention. Thus an activator that is equivalent in at least some respects to that described herein could be based on such other sources of halides as bromine, fluorine, and iodine. Salts of chlorine are used herein because they are inexpensive and readily available, and they provide a plating activator that is exceptionally effective as compared with conventional plating activators.

Accordingly, in 1 liter of the sensitizing activator for chemical plating, there are contained 0.015 to 0.03 grams/liter of vanillin, 5 to 10 grams/liter of stannous chloride, 0.1 to 0.2 grams/liter of palladium chloride, 0.5 to 5 volume/volume percent of sulfuric acid and 50 to 280 grams/liter of sodium chloride. The activator can be used, for example, in a saturated aqueous solution of sodium chloride (approximately 280 grams per liter) containing a small amount of sulfuric acid, from about 0.05 to 0.1 volume/volume percent of the sulfuric acid. For this example, 10 to 20 milliliters of a concentrate is added to 1 liter of the dilute sulfuric acid solution, the concentrate containing 0.015 to 0.03 grams of vanillin, 5 to 10 grams of stannous chloride and 0.1 to 0.2 grams of palladium chloride, in a saturated aqueous solution of sodium chloride.

The same concentrate can also be used in an aqueous solution containing about 50 grams per liter of the sodium chloride and from 3 to 10 volume/volume percent of sulfuric acid, the concentrate being added to 1 liter of the less dilute sulfuric acid solution. For this example, it is preferred that the sulfuric acid concentration be approximately 5 volume/volume percent, for a high level of activation and minimal effect on the substrate.

Hydrochloric acid, which is conventionally used in plating activators, is not used in the formulation of the present invention. The presence of chlorine ions, together with hydrogen ions that are introduced by the addition of sulfuric acid, suggests the presence of hydrochloric acid. However, the concentration of hydrogen ions is quite low in preferred formulations of the present invention, such that hydrochloric acid would be present in insignificant amounts, if at all. Also, hydrochloric acid, as such, cannot practically be recovered from the activator of the present invention. Accordingly, it is believed that the disadvantages associated with the incorporation of hydrochloric acid are not present in the activator described herein.

The stannous chloride and the palladium chloride are preferably separately dissolved in an aqueous solution having a high concentration of sodium chloride or other source of halides in the preparation of the activator. The sodium chloride, concentrated near saturation, acts to disperse the particles of the other salts. More preferably, the aqueous solution into which the stannous chloride and the palladium are dissolved also includes vanillin, for enhancing the dispersion of the dissolved components, and also for enhanced adhesion of the activator to the substrate.

It is believed that other polyvalent acids such as phosphoric acid could be used in place of all or part of the sulfuric acid. However, sulfuric acid is very inexpensive and readily available. Also, since the acid is being used primarily as an anti-oxidizing agent, it is believed that sulfuric acid provides results that are at least as satisfactory as any other cost-effective alternative.

The process for plating through holes of a multi-layer printed circuit board is generally conducted in the following order when using the activator of the present invention: a sensitizing treatment step, a soft etching step; an accelerating step; and a chemical plating step.

In the sensitizing treatment step, a substrate, which can be a copper-clad resin laminate board having through boles formed therein, is dipped in the sensitizing activator of the present invention and colloidal palladium in the sensitizing activator is deposited on the surface of the substrate, inclusive of the inner walls of the through holes, if any. In the soft etching step, the sensitized copper-clad resin laminate board is dipped in a suitably selected conventional etchant solution to finely coarsen the copper surface and remove the oxide film. The etchant can be a solution of sodium persulfate, preferably used as an aqueous solution in a volumetric concentration of approximately 10 percent. In each through hole, the sensitizing activator is left on the resin surface, and the sensitizing activator on the copper surface is removed because copper is slightly dissolved. In the accelerating step, the sensitizing activator deposited on the resin portion in the through holes of the copper-clad resin laminate board is activated to promote reaction of a chemical copper plating solution. The copper-clad resin laminate board which has passed through the soft etching step is dipped in an aqueous solution containing 10 volume/volume percent of sulfuric acid.

The sensitizing activator of the present invention is preferably used for plating of through holes of a multi-layer printed circuit board, but the use of the sensitizing activator is not limited to this plating and the sensitizing activator can be advantageously used in other aspects of circuit board plating, and for other chemical plating processes.

The present invention provides a number of advantages in chemical plating processes, for example:
(1) Since the sensitizing activator for chemical plating according to the present invention does not contain hydrochloric acid as an ingredient, the sensitizing activator has no adverse effect of corroding black copper oxide formed on an inner copper foil of a multi-layer substrate, and therefore, such conditions as the dipping time, the temperature and the concentration are not restricted and a sufficient sensitizing treatment can be attained.
(2) Since the sensitizing activator for chemical plating according to the present invention enables a sufficient sensitizing treatment and can deposit colloidal palladium uniformly on the surface of a material to be plated, even with only a single application of the sensitizing treatment, there can be obtained such a covering capacity that copper can be completely deposited by chemical plating. This is true even if soft etching, accelerating and chemical plating are repeated several times. Therefore, a complete treatment can be accomplished without occurrence of defects that are readily caused in the step of chemical plating of a multi-layer printed circuit board in the prior art, such as formation of voids (blank portions where chemical plating failed) because of a residual oxidizer or the like that was left after the treatment for removal of smear, commonly known as drill smear.

The present invention is advantageous over the conventional technique in the above-mentioned points in plating of through holes of a multi-layer printed circuit board. Also, in the sensitizing activator of the present invention, colloidal particles are more finely dispersed than in the conventional technique, and therefore, when the sensitizing activator of the present invention is used at the sensitizing treatment widely in general chemical plating, the sensitizing activator completely permeates and is absorbed in fine hole portions of the material to be plated. Thus excellent penetration and absorption as well as uniform chemical plating can be attained.

An exemplary formulation of the sensitizing activator of the present invention was prepared for use in chemical plating of through holes of a printed circuit board as follows: In 1 liter of an aqueous solution of sodium chloride having a saturation concentration and containing 1.5 grams of vanillin was dissolved under heating 500 grams of stannous chloride and 10 grams of powdery palladium chloride to form a starting solution. Then, about 10 ml of the starting solution was added to 1 liter of an aqueous solution containing 50 grams of sodium chloride and having a concentration of 5 to 10 volume/volume percent of sulfuric acid.

In a test of this formulation, a copper-clad glass-epoxy resin laminate board having through holes formed therein, which had been subjected to a customary degreasing treatment, was dipped in this sensitizing activator for 2 minutes to effect a sensitizing treatment. Then, the laminate board was passed through the washing step, the soft etching step, and the accelerating step and was then subjected to chemical plating of copper. A chemical plating layer free of voids was formed in a state closely adhering to the copper foil without causing corrosion of the black oxide of the inner copper foil of the copper-clad resin laminate board, and a chemical copper plating layer excellent in the reliability of conduction of electricity was uniformly formed in the entire plated through holes.

In a convenient process for producing the activator, 1 Kg of sodium chloride is added to 3 liters of water in a suitable container, the combination being heated to approximately 60°C to form a supersaturated solution. Next, two liters of saturated salt solution are poured off into another container, in which is operated a magnetic stirrer, and 3 grams of lignin vanillin (in crystalline form) are added, the temperature being maintained at approximately 60°C during stirring for from about 30 to about 40 minutes, or until the vanillin is completely dissolved. The resulting vanillin salt solution is then cooled, and can be stored indefinitely.

Next, 1 Kg of stannous chloride crystals are put into a 3000 ml beaker, the beaker being filled with part of the vanillin salt solution to a total volume of 1.9 liters. A slight amount of heat is applied for maintaining the temperature at from about 20°C to about 30°C, stirring occasionally until the crystals are dissolved. Also, 200 ml of the vanillin salt solution is put into a separate glass container, and 20 g of powdered palladium is slowly added while stirring with a magnetic stirrer, at from about 40°C to about 60°C. The addition of the palladium can normally be completed within about one minute. The stirring is continued for about one hour, or until the palladium is dissolved, as indicated by the absence of "grinding" sounds from the stirrer.

The dissolved palladium is next added to the stannous chloride salt solution in the 3000 ml beaker, while stirring, heat being applied for raising the temperature to about 80°C, preferably from about 78°C to about 82°C. Once the temperature reaches approximately 80°C, it is maintained at that level for one hour, then the resulting concentrate is cooled. It is intended that from 5% to about 10% of the contents of the beaker be lost to evaporation. Thus approximately two liters of the concentrate are produced as described above. If necessary, the beaker can be selected to provide a more desirable form factor for increasing or decreasing the rate of evaporation. Dilution of the concentration for use can be performed as in the examples given above, without the use of special techniques.

Although the present invention has been described in considerable detail with reference to certain preferred versions thereof, other versions are possible.

## Claims

1. A sensitizing activator for chemical plating, which comprises stannous chloride and palladium chloride, colloidally dispersed in an aqueous solution of sodium chloride, a concentration of an aromatic aldehyde, and a dilute concentration of a polyvalent acid.

2. The activator of claim 1 wherein the acid is sulphuric acid.

3. The activator of claim 1 wherein the aromatic aldehyde comprises vanillin.

4. The activator of claim 1 wherein the stannous chloride is in a concentration of from about 5 to about 10 grams per liter.

5. The activator of claim 1 wherein the palladium chloride is in a concentration of from about 0.1 to about 0.2 grams per liter.

6. The activator of claim 1 wherein the sodium chloride is in a concentration of from about 50 to about 280 grams per liter.

7. The activator of claim 1 wherein the acid is sulfuric acid in a volume concentration of from about 0.05 to about 10 percent.

8. The activator of claim 7 wherein the sodium chloride is in a concentration of about 280 grams per liter and the concentration of sulfuric acid is less than about 0.1 percent.

9. The activator of claim 7 wherein the sodium chloride is in a concentration of about 50 grams per litre and the concentration of sulphuric acid is about 5%.

10. The activator of claim 1 wherein the stannous chloride is in a concentration of from about 5 to about 10 grams per liter, the palladium chloride is in a concentration of from about 0.1 to about 0.2 grams per liter, the sodium chloride is in a concentration of from about 50 to about 280 grams per liter, and the acid is sulfuric acid in a volume concentration of from about 0.05 to about 5 percent.

11. A sensitizing activator for chemical plating, comprising stannous chloride and palladium chloride colloidally dispersed in an aqueous solution of sodium chloride and a concentration of an aromatic aldehyde, the stannous chloride and the palladium chloride having weight per unit volume concentrations in a ratio of from about 25 to about 100 for stannous chloride per unit of palladium chloride.

12. The activator of claim 11 wherein the stannous chloride is in a concentration of about 500 grams per litre.

13. The activator of claim 11 or 12 wherein the palladium chloride is in a concentration of from about 10 to about 20 grams per litre.

14. The activator of any one of claims 11 to 13 wherein the sodium chloride is in a concentration of from about 50 to about 280 grams per litre.

15. The activator of claim 12 wherein the palladium chloride is in a concentration of from about 10 to about 20 grams per liter.

16. The activator of claim 12 wherein the sodium chloride is in a concentration of from about 50 to about 280 grams per liter.

17. The activator of claim 12 further comprising vanillin in a weight concentration of from about 0.075 to about 0.3 per unit of palladium chloride.

18. The activator of claim 17 wherein the concentration of vanillin is about 0.15 per unit of palladium chloride.

19. The activator of claim 18 wherein the sodium chloride is in a concentration of about 280 grams per liter and the sulfuric acid is in a volumetric concentration of between about 0.05 and about 0.1 percent.

20. The activator of claim 18 wherein the sodium chloride is in a concentration of about 50 grams per liter and the sulfuric acid is in a volumetric concentration of about 5 percent.

21. A sensitizing activator for chemical plating, which comprises stannous chloride in a concentration of about 5 grams per liter and palladium chloride in a concentration of about 0.1 grams per liter, colloidally dispersed in an aqueous solution of sodium chloride in a concentration of about 50 to about 280 grams per liter and vanillin in a concentration of about 0.015 grams per liter, and sulfuric acid having a volume concentration of from about 0.05 to about 5 percent.

22. A method for plating a substrate, comprising the steps of:
(a) dipping the substrate into a sensitizing activator comprising:
(i) stannous chloride;
(ii) palladium chloride;
(iii) sodium chloride in an aqueous solution, wherein the weight of stannous chloride is from about 25 to about 100 times the weight concentration of palladium chloride; and
(iv) sulfuric acid in a volumetric concentration of from about 0.05% to about 5%;
and (v) an aromatic aldehyde
(b) rinsing the substrate; and
(c) dipping the substrate into a chemical plating bath comprising the metal to be plated.

23. The method of claim 22 wherein the weight concentration of stannous chloride is approximately 50 times the weight concentration of palladium chloride.

24. The method of claim 23 wherein the board comprises a substrate having copper cladding, the method further comprising, following the step of dipping the board into the sensitizing activator, the further step of dipping the substrate in an etching solution for etching an oxide film from the cladding.

25. The method of claim 24 wherein the etching solution comprises an aqueous solution of sodium persulfate in a volumetric concentration of approximately 10 percent.

26. The method of claim 22 further comprising, following the step of dipping the board into the sensitizing activator, the further step of dipping the substrate in an aqueous solution of sulfuric acid in a volumetric concentration of approximately 10 percent for accelerating the plating.

27. A method for producing a sensitizing activator for chemical plating, comprising the steps of:
(a) preparing an aqueous solution of sodium chloride and an aromatic aldehyde;
(b) dissolving stannous chloride in a first portion of the sodium chloride solution;
(c) dissolving palladium chloride in a second portion of the sodium chloride solution; and
(d) adding the dissolved palladium chloride to the dissolved sodium chloride.

28. The method of claim 27 comprising the further step of heating the combination of the dissolved stannous chloride and the palladium chloride to a temperature of approximately 80°C for a duration of approximately one hour.

29. The method of claim 27 wherein the solution of sodium chloride is a saturated solution.

## Patentansprüche

1. Sensibilisierungsaktivator für einen chemischen Plattierungsvorgang, der Zinndichlorid und Palladiumchlorid, die kolloidal in einer wässrigen Lösung aus Natriumchlorid dispergiert sind, eine Konzentration eines aromatischen Aldehyds und eine verdünnte Konzentration einer mehrwertigen Säure umfaßt.

2. Aktivator nach Anspruch 1, bei dem die Säure eine Schwefelsäure ist.

3. Aktivator nach Anspruch 1, bei dem das aromatische Aldehyd Vanillin umfaßt.

4. Aktivator nach Anspruch 1, bei dem das Zinndichlorid in einer Konzentration von etwa 5 big etwa 10 Gramm pro Liter vorliegt.

5. Aktivator nach Anspruch 1, bei dem das Palladiumchlorid in einer Konzentration von etwa 0,1 bis etwa 0,2 Gramm pro Liter vorliegt.

6. Aktivator nach Anspruch 1, bei dem das Natriumchlorid in einer Konzentration von etwa 50 bis etwa 280 Gramm pro Liter vorliegt.

7. Aktivator nach Anspruch 1, bei dem die Säure eine Schwefelsäure in einer Volumenkonzentration von etwa 0,05 bis etwa 10 Prozent vorliegt.

8. Aktivator nach Anspruch 7, bei dem das Natriumchlorid in einer Konzentration von etwa 280 Gramm pro Liter vorliegt und die Konzentration der Schwefelsäure weniger als etwa 0,1 Prozent beträgt.

9. Aktivator nach Anspruch 7, bei dem das Natriumchlorid in einer Konzentration von etwa 50 Gramm pro Liter vorliegt und die Konzentration der Schwefelsäure etwa 5% beträgt.

10. Aktivator nach Anspruch 1, bei dem das Zinndichlorid in einer Konzentration von etwa 5 bis etwa 10 Gramm pro Liter vorliegt, das Palladiumchlorid in einer Konzentration von etwa 0,1 bis etwa 0,2 Gramm pro Liter vorliegt, das Natriumchlorid in einer Konzentration von etwa 50 bis etwa 280 Gramm pro Liter vorliegt, und die Säure eine Schwefelsäure mit einer Volumenkonzentration von etwa 0,05 bis 5 Prozent ist.

11. Sensibilisierungsaktivator für einen chemischen Plattierungsvorgang, mit Zinndichlorid und Palladiumchlorid, die kolloidal in einer wässrigen Lösung aus Natriumchlorid dispergiert sind, und einer Konzentration eines aromatischen Aldehyds, wobei das Zinndichlorid und das Palladiumchlorid Konzentrationen von Gewicht pro Volumeneinheit in einem Verhältnis von etwa 25 bis etwa 100 für Zinndichlorid pro Einheit Palladiumchlorid aufweisen.

12. Aktivator nach Anspruch 11, bei dem das Zinndichlorid in einer Konzentration von etwa 500 Gramm pro Liter vorliegt.

13. Aktivator nach Anspruch 11 oder 12, bei dem das Palladiumchlorid in einer Konzentration von etwa 10 bis 20 Gramm pro Liter vorliegt.

14. Aktivator nach einem der Ansprüche 11 bis 13, bei dem das Natriumchlorid in einer Konzentration von etwa 50 bis etwa 280 Gramm pro Liter vorliegt.

15. Aktivator nach Anspruch 12, bei dem das Palladiumchlorid in einer Konzentration von etwa 10 bis etwa 20 Gramm pro Liter vorliegt.

16. Aktivator nach Anspruch 12, bei dem das Natriumchlorid in einer Konzentration von etwa 50 bis etwa 280 Gramm pro Liter vorliegt.

17. Aktivator nach Anspruch 12, desweiteren mit Vanillin in einer Gewichtskonzentration von etwa 0,075 bis etwa 0,3 pro Einheit Palladiumchlorid.

18. Aktivator nach Anspruch 17, bei dem die Konzentration des Vanillins etwa 0,15 pro Einheit Palladiumchlorid beträgt.

19. Aktivator nach Anspruch 18, bei dem das Natriumchlorid in einer Konzentration von etwa 280 Gramm pro Liter vorliegt und die volumetrische Konzentration der Schwefelsäure zwischen etwa 0,05 und etwa 0,1 Prozent liegt.

20. Aktivator nach Anspruch 18, bei dem das Natriumchlorid in einer Konzentration von etwa 50 Gramm pro Liter vorliegt und die Schwefelsäure in einer volumetrischen Konzentration von etwa 5 Prozent vorliegt.

21. Sensibilisierungsaktivator für einen chemischen Plattierungsvorgang, der Zinndichlorid in einer Konzentration von etwa 5 Gramm pro Liter und Palladiumchlorid in einer Konzentration von etwa 0,1 Gramm pro Liter, die kolloidal in einer wässrigen Lösung von Natriumchlorid in einer Konzentration von etwa 50 bis etwa 280 Gramm pro Liter dispergiert sind, und Vanillin in einer Konzentration von etwa 0,015 Gramm pro Liter und Schwefelsäure mit einer Volumenkonzentration von etwa 0,05 bis etwa 5 Prozent umfaßt.

22. Verfahren zum Plattieren eines Substrats, das die folgenden Schritte umfaßt:
a) Eintauchen des Substrats in einen Sensibilisierungsaktivator, mit:
(i) Zinndichlorid,
(ii) Palladiumchiorid,
(iii) Natriumchlorid in einer wässrigen Lösung, wobei das Gewicht des Zinndichlorids das etwa 25- bis etwa 100fache der Gewichtskonzentration von Palladiumchlorid beträgt, und
(iv) Schwefelsäure in einer volumetrischen Konzentration von etwa 0,05% bis etwa 5%;
und (v) einem aromatischen Aldehyd
b) Abspülen des Substrats; und
c) Eintauchen des Substrats in ein chemisches galvanisches Bad, das das aufzubringende Metall umfaßt.

23. Verfahren nach Anspruch 22, bei dem die Gewichtskonzentration des Zinndichlorids das etwa 50fache der Gewichtskonzentration von Palladiumchlorid beträgt.

24. Verfahren nach Anspruch 23, bei dem die Tafel ein Substrat mit einem Kupferüberzug umfaßt, wobei das Verfahran nach dem Schritt des Eintauchens der Tafel in den Sensibilisierungsaktivator desweiteren den weiteren Schritt des Eintauchens des Substrats in eine Ätzlösung zum Wegätzen einer Oxidschicht von der Plattierung umfaßt.

25. Verfahren nach Anspruch 24, bei dem die Ätzlösung eine wässrige Lösung aus Natriumpersulfat in einer volumetrischen Konzentration von etwa 10 Prozent umfaßt.

26. Verfahren nach Anspruch 22, nach dem Schritt des Eintauchens der Tafel in den Sensibilisierungsaktivator desweiteren mit dem weiteren Schritt des Eintauchans des Substrats in eine wässrige Lösung aus Schwefelsäuure in einer volumetrischen Konzentration von etwa 10 Prozent zur Beschleunigung des Plattierungsvorgangs.

27. Verfahren zur Herstellung eines Sensibilisierungsaktivators für einen chemischen Plattierungsvorgang, mit den folgenden Schritten:
a) Herstellen einer wässrigen Lösung aus Natriumchlorid und einem aromatischen Aldehyd;
b) Auflösen des Zinndichlorids in einem ersten Teil der Natriumchloridlösung;
c) Auflösen des Palladiumchlorids in einem zweiten Teil der Natriumcvhloridlösung; und
d) Hinzufügen des gelösten Palladiumchlorids zu dem gelösten Natriumchlorid.

28. Verfahren nach Anspruch 27, mit dem weiteren Schritt des Erwärmens der Kombination aus dem gelösten Zinndichlorid und dem Palladiumchlorid auf eine Temperatur von etwa 80°C über einen Zeitraum von etwa einer Stunde.

29. Verfahren nach Anspruch 27, bei dem die Lösung aus Natriumchlorid eine gesättigte Lösung ist.

## Revendications

1. Promoteur pour revêtement chimique qui comprend du chlorure stanneux et du chlorure de palladium, dispersés de façon colloïdale dans une solution aqueuse de chlorure de sodium, une proportion d'un aldéhyde aromatique et une porportion diluée d'une acide polyvalent.

2. Promoteur selon la revendication 1, dans lequel l'acide est l'acide sulfurique.

3. Promoteur selon la revendication 1, dans lequel l'aldéhyde aromatique est la vanilline.

4. Promoteur selon la revendication 1, dans lequel le chlorure stanneux est présent en une proportion d'environ 5 à environ 10 g/l.

5. Promoteur selon la revendication 1, dans lequel le chlorure de palladium est présent en une proportion d'environ 0,1 à environ 0,2 g/l.

6. Promoteur selon la revendication 1, dans lequel le chlorure de sodium est présent en une proportion d'environ 50 à environ 280 g/l.

7. Promoteur selon la revendication 1, dans lequel l'acide est l'acide sulfurique en une proportion en volume d'environ 0,05 à environ 10%.

8. Promoteur selon la revendication 7, dans lequel le chlorure de sodium est présent en une proportion d'environ 280 g/l et l'acide sulfurique en une proportion inférieure à environ 0,1%.

9. Promoteur selon la revendication 7, dans lequel le chlorure de sodium est présent en une proportion d'environ 50 g/l et l'acide sulfurique en une proportion d'environ 5%.

10. Promoteur selon la revendication 1, dans lequel le chlorure stanneux est présent en une proportion d'environ 5 à environ 10 g/l, le chlorure de palladium en une proportion d'environ 0,1 à environ 0,2 g/l, le chlorure de sodium en une proportion d'environ 50 à environ 280 g/l et l'acide est l'acide sulfurique en une proportion en volume d'environ 0,05 à environ 5%.

11. Promoteur pour revétemert chimique comprenant du chlorure stanneux et du chlorure de palladium, dispersés de façon colloïdale en solution aqueuse de chlorure de sodium et une proportion d'un aldéhyde aromatique, le chlorure stanneux et le chlorure de palladium ayant des proportions en poids par unité de volume dans un rapport d'environ 25 à environ 100 pour le chlorure stanneux par unité de chlorure de palladium.

12. Promoteur selon la revendication 11, dans lequel le chlorure stanneux est présent en une proportion d'environ 500 g/l.

13. Promoteur selon la revendication 11 ou 12, dans lequel le chlorure de palladium est présent en une proportion 10 à environ 20 g/l.

14. Promoteur selon l'une quelconque des revendications 11 à 13, dans lequel le chlorure de sodium est présent en une proportion d'environ 50 à environ 280 g/l.

15. Promoteur selon la revendication 12, dans lequel le chlorure de palladium est présent en une proportion d'environ 10 à environ 20 g/l.

16. Promoteur selon la revendication 12, dans lequel le chlorure de sodium est en une proportion d'environ 50 à environ 280 g/l.

17. Promoteur selon la revendication 12, comprenant en outre de la vanilline en une proportion en poids d'environ 0,075 à environ 0,3 par unité de chlorure de palladium.

18. Promoteur selon la revendication 17, dans lequel la proportion en vanilline est d'environ 0,15 par unité de chlorure de palladium.

19. Promoteur selon la revendication 18, dans lequel le chlorure de sodium est en une proportion d'environ 280 g/l et l'acide sulfurique en une concentration volumétrique d'environ 0,05 et environ 0,1%.

20. Promoteur selon la revendication 18, dans lequel le chlorure de sodium est présent en une proportion d'environ 50 g/l et l'acide sulfurique en une proportion volumétrique d'environ 5%.

21. Promoteur de revêtement chimique qui comprend du chlorure stanneux en une proportion d'environ 5 g/l et du chlorure de palladium en une proportion d'environ 0,1 g/l, dispersés de façon colloïdale dans une solution aqueuse de chlorure de sodium en une proportion d'environ 50 à environ 280 g/l et de la vanilline en une proportion d'environ 0,015 g/l et de l'acide sulfurique en une proportion en volume d'environ 0,05 à environ 5%.

22. Procédé pour le revêtement d'un substrat comprenant les étapes consistant :
(a) à plonger le substrat dans un promoteur comprenant :
(i) du chlorure stanneux;
(ii) du chlorure de palladium;
(iii) du chlorure de sodium en solution aqueuse, dans lequel le poids de chlorure stanneux est d'environ 25 à environ 100 fois la concentration en poids du chlorure de palladium et
(iv) de l'acide sulfurique en une proportion volumétrique d'environ 0,05% à environ 5% et
(v) un aldéhyde aromatique,
(b) à rincer le substrat et
(c) à plonger le substrat dans un bain chimique de revêtement comprenant le métal à revêtir.

23. Procédé selon la revendication 22, dans lequel la proportion en poids de chlorure stanneux est approximativement de 50 fois la proportion en poids de chlorure de palladium.

24. Procédé selon la revendication 23, dans lequel la plaque possède un placage de cuivre, ledit procédé comprenant en outre, après l'étape d'immersion de la plaque dans le promoteur, l'étape ultérieure d'immersion du substrat dans une solution de mordant pour corroder un film d'oxyde du placage.

25. Procédé selon la revendication 24, dans lequel la solution de mordant est constituée d'une solution aqueuse de persulfate de sodium en une proportion volumétrique d'environ 10%.

26. Procédé selon la revendication 22, qui comprend en outre après l'étape d'immersion de la plaque dans le promoteur, l'étape ultérieure d'immersion de substrat dans une solution aqueuse d'acide sulfurique en une proportion volumétrique d'environ 10% pour accélérer le revétement.

27. Procédé pour la préparation d'un promoteur pour revêtement chimique, comprenant les étapes consistant :
(a) à préparer une solution aqueuse de chlorure de sodium et d'un aldéhyde aromatique,
(b) à dissoudre le chlorure stanneux dans une première fraction de la solution de chlorure de sodium;
(c) à dissoudre le chlorure de palladium dans une seconde fraction de la solution de chlorure de sodium; et
(d) à ajouter le chlorure de palladium dissous au chlorure de sodium dissous.

28. Procédé selon la revendication 27, comprenant en outre une étape de chauffage de la combinaison du chlorure stanneux dissous et du chlorure de palladium à une température d'environ 80°C pendant une durée d'environ une heure.

29. Procédé selon la revendication 27, dans lequel la solution de chlorure de sodium est une solution saturée.
